# FASCICULE DE BREVET EUROPEEN

(11) **EP 2 681 768 B1**
(45) Date de publication et mention de la délivrance du brevet: **29.11.2017**
(21) Numéro de dépôt: 12709930.7
(22) Date de dépôt: 17.02.2012
(51) Int. Cl.: H01L 31/18, H01L 31/0465

(54) **PROCÉDÉ POUR LA MISE EN SÉRIE ÉLECTRIQUE MONOLITHIQUE DE CELLULES PHOTOVOLTAÏQUES D'UN MODULE SOLAIRE ET MODULE PHOTOVOLTAÏQUE OBTENU PAR CE PROCÉDÉ**
VERFAHREN ZUR MONOLITISCHEN SERIENVERSCHALTUNG VON PHOTOVOLTAISCHEN ZELLEN EINES PHOTOVOLTAIKMODULS UND DADURCH HERGESTELLTES PHOTOVOLTAIKMODUL
PROCESS FOR MONOLITHIC SERIES CONNECTION OF THE PHOTOVOLTAIC CELLS OF A SOLAR MODULE AND A PHOTOVOLTAIC MODULE OBTAINED BY THIS PROCESS

(30) Priorité: 01.03.2011 FR 1151652
(43) Date de publication de la demande: 08.01.2014
(73) Titulaire: Commissariat à l'Énergie Atomique et aux Énergies Alternatives, 75015 Paris (FR)
(72) Inventeur: SEILER, Anne-Laure, 38170 Seyssinet Pariset (FR); CORONEL, Philippe, 38530 Barraux (FR); DUFOURCQ, Joël, 64270 Puyoo (FR)
(74) Mandataire: Cabinet Laurent & Charras
(86) Numéro de dépôt international: PCT/FR2012/050348
(87) Numéro de publication internationale: WO 2012/117182

(56) Documents cités:
- WO-A2-2009/007375
- US-A1- 2010 015 752

## Description

### DOMAINE DE L'INVENTION

L'invention concerne le domaine des cellules photovoltaïques et plus particulièrement un procédé de fabrication d'une zone de connexion en série monolithique de cellules photovoltaïques.

### ETAT DE LA TECHNIQUE

Comme cela est connu en soi, les modules photovoltaïques, ou modules « solaires », comprennent un ou plusieurs agencements en série de cellules photovoltaïques, chacune constituée d'une zone semi-conductrice d'absorption intercalée entre une première électrode conductrice et une seconde électrode conductrice transparente à la lumière, constituant la face par laquelle la cellule est éclairée par le rayonnement solaire. La première électrode est communément appelée électrode « arrière » et la seconde électrode est communément appelée électrode « avant ».

Pour des raisons de coût et de simplicité de fabrication, l'une des technologies utilisées, appelée « technologie en couche mince », consiste à fabriquer les cellules collectivement en déposant sur un substrat isolant un empilement constitué, dans l'ordre:
- d'une première couche électriquement conductrice,
- d'une première couche semi-conductrice d'absorption,
- d'une deuxième couche semi-conductrice formant une hétérojonction avec la première couche semi-conductrice,
- d'une deuxième couche électriquement conductrice transparente à la lumière.

Les cellules photovoltaïques sont ensuite individualisées en formant des tranchées dans l'empilement.

Par ailleurs, la mise en série électrique de deux cellules photovoltaïques adjacentes est préférentiellement réalisée en fabriquant une zone de connexion dans l'empilement qui définit à la fois l'individualisation des deux cellules et connecte une électrode avant de l'une des cellules avec l'électrode arrière de l'autre cellule en utilisant uniquement que les couches constitutives de l'empilement.

Ce type de connexion électrique dite « monolithique », présente l'avantage de ne pas avoir à mécaniquement séparer les cellules pour ensuite les reporter dans un boitier de connexion réalisant leur mise en série, et évite également l'emploi de liaisons filaires et de soudure. En outre, un gain de coût de fabrication et un gain de compacité sont également obtenus.

Un procédé de fabrication d'un module photovoltaïque 10 de l'état de la technique est décrit en se référant aux figures 1 à 5.
La figure 1 est une vue schématique de la face avant d'un module **10** comprenant cinq cellules photovoltaïques **12, 14, 16, 18, 20** montées électriquement en série par des zones de connexion monolithiques **22, 24, 26, 28.**
Les figures 2 à 5 sont des vues schématiques en coupe selon le plan A-A de la figure 1 illustrant le procédé de fabrication du module **10.**

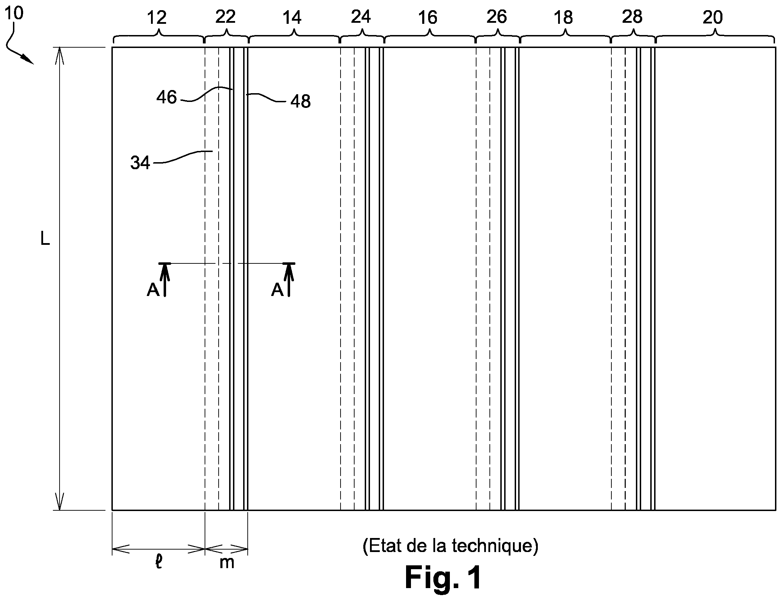

La figure 1 n'est pas à l'échelle, la largeur des zones de connexion monolithique **22, 24, 26, 28** ayant été exagérée afin de les rendre plus visibles. Notamment, la longueur *L* des cellules photovoltaïques **12, 14, 16, 18, 20** est comprise usuellement entre 1 millimètre et la dizaine de centimètres, ladite longueur *L* pouvant même être supérieure au mètre, la largeur *l* des cellules photovoltaïques **12, 14, 16, 18, 20** est usuellement de l'ordre du centimètre, alors que la largeur *m* des zones de connexion monolithiques **22, 24, 26, 28** est usuellement comprise entre 100 et 300 micromètres.

Le procédé de fabrication du module **10** débute par le dépôt d'une couche conductrice **30,** usuellement une couche métallique en un métal dur, préférentiellement du molybdène, sur un substrat isolant **32,** usuellement en verre, en plastique ou en métal recouvert d'une couche isolante.

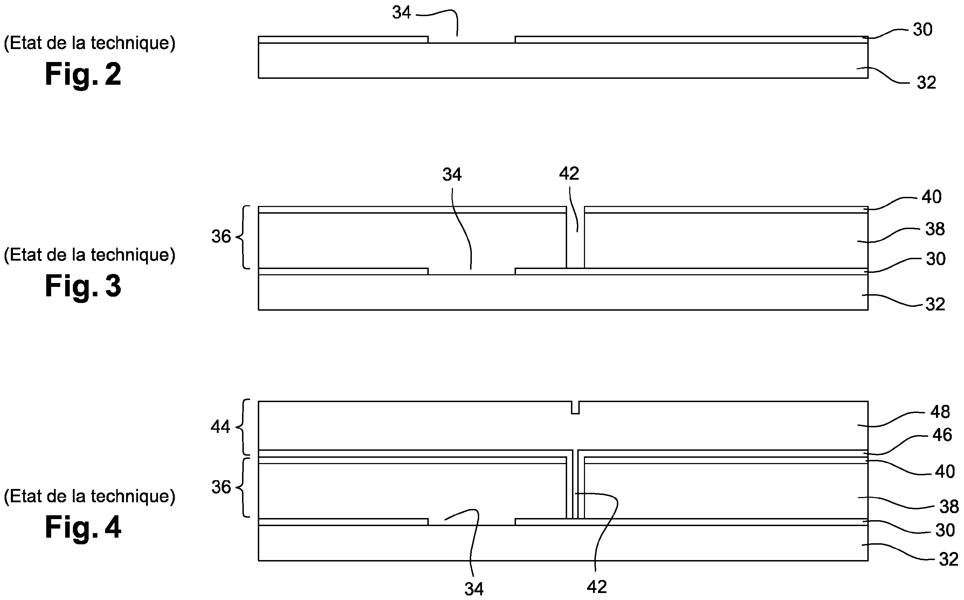

Pour chaque zone de connexion monolithique, une gravure **34** est réalisée dans la couche métallique **30** sur toute la longueur de celle-ci, par exemple au moyen d'un laser UV ou IR délivrant des impulsions de quelques picosecondes à quelques nanosecondes (figure 2).

Une couche semi-conductrice **36** de quelques micromètres d'épaisseur, par exemple 2 micromètres, est ensuite déposée sur la couche métallique **30** et la gravure **34.**

La couche semi-conductrice **36** est usuellement réalisée sous la forme d'un bicouche ayant une première couche inférieure **38** et une deuxième couche supérieure **40.** La couche inférieure **38** assure la fonction d'absorption d'un rayonnement électromagnétique prédéterminé et est réalisée en un alliage poly-cristallin comprenant au moins du cuivre, de l'indium, du galium et du sélénium, plus communément connu sous le nom d'alliage « CIGS ». La couche supérieure **40** forme une hétérojonction avec la couche semi-conductrice inférieure **38,** et est par exemple constituée d'une couche de sulfure de cadmium (CdS) de quelques dizaines de nanomètres d'épaisseur, par exemple 60 nanomètres.

Une première tranchée **42** est alors gravée dans l'empilement ainsi réalisé, sur toute la longueur *L* de celui-ci, jusqu'à la première couche métallique **30** (figure 3).

Une couche **44** conductrice et transparente à la lumière est alors réalisée sur la couche semi-conductrice **36.** La couche **44** comprend par exemple une couche électriquement conductrice et transparente **48** d'une centaine de nanomètres d'épaisseur, par exemple 500 nanomètres, notamment du ZnO dopé par de l'aluminium (ZnOAl) (figure 3). Sa fonction est améliorée par la présence d'une couche optionnelle **46,** notamment une couche d'oxyde de zinc (ZnO), très mince, typiquement de quelques dizaines de nanomètres d'épaisseur, par exemple 50 nanomètres, plutôt résistive, qui permet d'éviter la formation de court-circuits avec la couche semi-conductrice **36** lorsque l'état de surface de la couche **38** n'est pas très bon.

Le matériau constitutif de la couche supérieure **48** remplit donc la tranchée **42** (figure 4). On notera que la couche semi-conductrice **44** peut également être uniquement constituée de la couche supérieure **48.** La fonction de la couche **48** est cependant améliorée par la présence de la couche optionnelle **46,** très mince et relativement résistive, qui permet d'éviter des courts-circuits avec la jonction **36** lorsque l'état de surface de la couche semi-conductrice inférieure **38** n'est pas de qualité suffisante.

Le procédé se poursuit alors par la réalisation, pour chaque zone de connexion monolithique **22, 24, 26, 28,** d'une seconde tranchée **50,** parallèle à la première tranchée **42,** dans l'épaisseur de l'empilement ainsi réalisé, sur toute la longueur *L* de celui-ci et jusqu'à la couche métallique **30.** Dans l'exemple des matériaux précédemment décrits, les couches **36** et **44** sont friables et la couche métallique **30** a une dureté plus élevée que celle des couches **36, 44.**

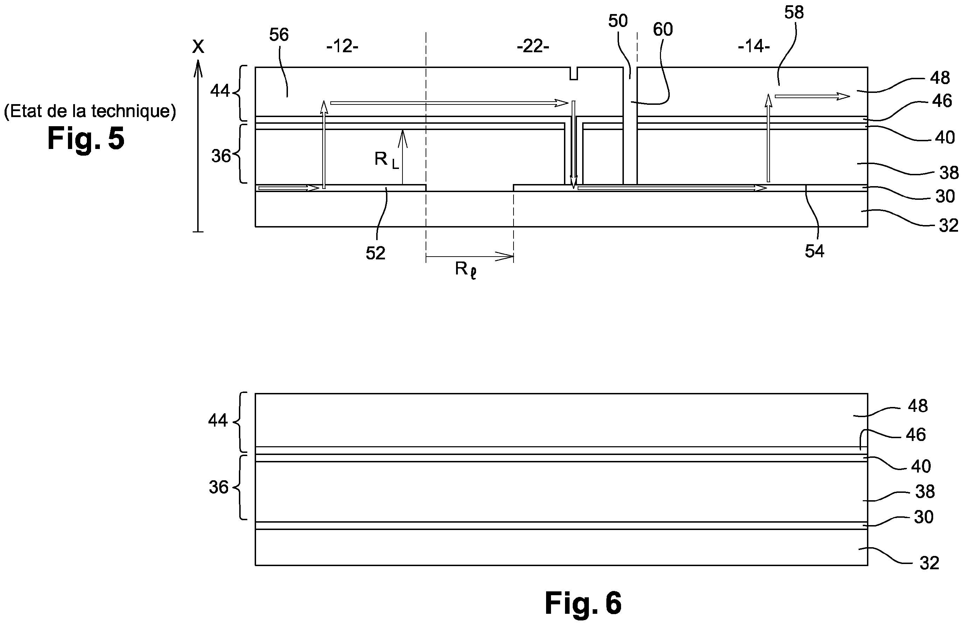

La seconde tranchée **50,** comme la première tranchée **42,** est usuellement réalisée en une seule étape en rayant l'empilement au moyen d'un stylet (figure 5).

Ainsi, la fabrication d'une zone de connexion monolithique, la zone **22** dans l'exemple illustré aux figures 2 à 5, a pour effet de délimiter deux cellules photovoltaïques adjacentes **12** et **14.**

Notamment, la gravure **34** sépare les électrodes arrière **52, 54** des cellules **12** et **14,** l'isolation électrique entre les deux électrodes arrière ainsi formées étant réalisée par le matériau semi-conducteur de la couche absorbante **38** qui les sépare.

La première et la seconde tranchées **42, 50** sont réalisées au dessus de la même électrode arrière **54.** La seconde tranchée **50,** non adjacente à la gravure **34,** sépare quant à elle les électrodes avant **56, 58** des cellules **12, 14,** l'isolation électrique entre les deux électrodes avant **56, 58** ainsi formées étant réalisée par le milieu **60** remplissant la seconde tranchée **50,** usuellement de l'air.

La première tranchée **42,** remplie par le matériau conducteur de la couche **48,** a quant à elle pour fonction de définir un chemin électrique. Ainsi, la zone de connexion **22** définit un chemin électrique illustré par les flèches de la figure 5, mettant électriquement en série ces cellules, c'est-à-dire connectant électriquement l'électrode avant **56** de la cellule **12** avec l'électrode arrière **54** de la cellule **14.**

Dans ce qui suit, le terme « transversal » se rapporte à la direction de l'empilement, illustrée par la flèche *X* sur la figure 5, et le terme « latéral » se rapporte à une direction perpendiculaire à la direction de l'empilement.

Il peut être remarqué toutefois que l'isolation électrique entre les électrodes arrière **52, 54** dépend de la valeur de la résistance électrique latérale totale *Rₗ* de la zone du matériau semi-conducteur remplissant la gravure **34,** et plus particulièrement de son rapport avec la résistance électrique totale transversale *R_{L}* de la couche semi-conductrice **38.**

En effet, le courant électrique circule préférentiellement selon le chemin de plus faible résistance électrique, de sorte qu'il convient de s'assurer que la résistance latérale *Rₗ* soit très supérieure à la résistance transversale *R_{L}*.

Afin d'obtenir ce résultat, la largeur de la tranchée **34** nécessite d'être très élevée. Ainsi par exemple, alors même que le CIGS poly-cristallin possède une résistance électrique latérale linéique très supérieure à sa résistance électrique transversale linéique en raison de la direction de croissance des cristaux lors du dépôt de la couche **38,** il est nécessaire de prévoir une tranchée **34** d'une largeur d'au moins 100 micromètres. De fait, la largeur de la zone de connexion monolithique est pour une bonne part dictée par la largeur de la gravure **34.** Ainsi, une surface non négligeable est perdue pour l'absorption des photons. En outre, même si la largeur de la gravure **34** garantit une isolation électrique minimale entre les électrodes arrière de deux cellules photovoltaïques adjacentes, cette isolation électrique reste cependant encore trop faible, de sorte qu'il est observé des courants de fuite entre deux électrodes arrière, ce qui nuit aux performances globales du module solaire. Ce défaut s'aggrave d'autant plus que les composants sont miniaturisés.

Ainsi donc les zones de connexion monolithiques de l'état antérieur de la technique permettent un gain notable de coût, de compacité et de facilité de connexion, mais présentent intrinsèquement des limitations concernant l'isolation électrique des électrodes arrière des cellules photovoltaïques.

Le document WO2009007375 illustre des méthodes de l'état de la technique pour l'interconnexion de cellules solaires en couches minces adjacentes sur un substrat isolant.

### EXPOSE DE L'INVENTION

Le but de la présente invention est de proposer des zones de connexion monolithiques pour module photovoltaïque, ainsi qu'un procédé de fabrication de celles-ci, qui augmentent de manière sensible l'isolation électrique entre les électrodes arrière des cellules photovoltaïques constitutives du module.

A cet effet, l'invention a pour objet un procédé de fabrication d'un module photovoltaïque comprenant au moins deux cellules photovoltaïques adjacentes connectées électriquement en série, comprenant :
la formation d'un substrat isolant;
▪ la formation d'un empilement comprenant :
   ∘ une première couche conductrice de l'électricité formée sur le substrat isolant ;
   ∘ une couche semi-conductrice comportant une première couche semi-conductrice d'absorption d'un rayonnement électromagnétique prédéterminé, formée sur la première couche conductrice, et une seconde couche semi-conductrice formant une jonction avec la première couche semi-conductrice d'absorption et formée sur celle-ci ; et
   ∘ une deuxième couche conductrice de l'électricité et au moins partiellement transparente audit rayonnement, formée sur la couche semi-conductrice ;
▪ la formation d'au moins une zone de connexion divisant l'empilement en une première et une deuxième cellules photovoltaïques adjacentes électriquement connectées uniquement par un chemin électrique entre une portion de la première couche conductrice de la première cellule et une portion de la deuxième couche conductrice de la deuxième cellule.

Selon l'invention, la formation dudit chemin électrique comporte :
▪ la formation d'une première tranchée dans l'empilement depuis la deuxième couche conductrice jusqu'au substrat ;
▪ la formation d'une deuxième tranchée, distincte de la première tranchée, depuis la deuxième couche conductrice jusqu'à la première couche conductrice ; et
▪ le dépôt d'une solution conductrice sur une zone de la deuxième couche semi-conductrice comprenant la première tranchée et au moins une portion de la deuxième tranchée située du côté de la première tranchée, la géométrie des tranchées, l'épaisseur de la deuxième couche conductrice, et la quantité et les propriétés de la solution conductrice lors de son dépôt étant choisies de manière à ce que la solution conductrice ne pénètre pas dans la première tranchée jusqu'à la première couche conductrice et pénètre dans la deuxième tranchée jusqu'à la première couche conductrice.

Par solution, on entend ici un liquide, qui a donc une aptitude à se déformer sous l'effet de son propre poids et des phénomènes de capillarité. A titre d'exemple illustratif de cette définition, on peut par exemple citer une encre composée d'un solvant volatile avec des particules conductrices, notamment métalliques, en suspension. A titre d'exemple supplémentaire, on peut également citer les pates opaques comme les encres d'argent ou les encres de carbones-platines, et les pates transparentes comme les encres d'oxyde indium-étain, ou encres « ITO » (pour « indium tin oxyde »)

En d'autres termes, les électrodes arrière des cellules photovoltaïques adjacentes sont, selon l'invention, séparées, non pas par le matériau semi-conducteur de la couche d'absorption, mais par une cavité remplie du gaz baignant le module lors de sa fabrication, à savoir usuellement de l'air. Or, l'air présente une résistance électrique très supérieure à la résistance électrique de n'importe quel semi-conducteur, y compris la résistance électrique latérale des matériaux semi-conducteurs poly-cristallins, tels que les alliages poly-cristallin en CIGS. Il est donc obtenu un gain sensible d'isolation électrique entre les électrodes arrière de cellules photovoltaïque adjacentes.

Le procédé selon l'invention, outre son but premier de fabriquer une cavité remplie d'air entre des électrodes arrière, présente également l'avantage de conserver une fabrication de l'empilement la plus simple qui soit, à savoir une simple formation successive de couches.

On comprend en effet qu'en réalisant une cavité trop tôt, par exemple une fois la couche semi-conductrice d'absorption terminée, il est nécessaire de prévoir des mesures de protection de la cavité formée lors du dépôt des couches ultérieures. Dans le cas contraire, la cavité serait remplie par le matériau constitutif desdites couches, et notamment par le matériau conducteur de la deuxième couche conductrice, ce qui conduirait à un court-circuit entre les électrodes avant et arrière d'une même cellule. De telles mesures reviennent donc à prévoir un masque de protection de la cavité pour chaque étape de dépôt d'une nouvelle couche, ce qui multiplie les étapes de fabrication et donc le coût final du module.

Selon le procédé de l'invention, c'est seulement une fois l'empilement terminé que la cavité est réalisée, notamment par l'utilisation d'une simple gravure dans l'épaisseur de l'empilement. La connexion électrique entre l'électrode avant d'une cellule avec l'électrode arrière d'une autre cellule adjacente est alors réalisée simplement par le dépôt d'une solution conductrice judicieusement choisie qui ne remplit pas la cavité et évite leur court-circuit. On comprend alors aisément que le procédé de fabrication de l'invention, par ce choix du moment de réalisation de la cavité combiné avec le choix d'une solution conductrice appropriée, est très simple de mise en oeuvre, et nécessite un nombre très restreint d'étapes.

Une fois ceci posé, il est également aisé de comprendre qu'il existe une multitude de possibilités pour obtenir le résultat de « non pénétration » de la solution conductrice dans la première tranchée. En effet, la profondeur de pénétration d'une solution dans une tranchée dépend notamment :
▪ de la largeur de la tranchée, et de manière plus générale de sa géométrie ;
▪ de la viscosité de la solution et des phénomènes de capillarité qui font intervenir la tension superficielle de la solution, les énergies de surface et les affinités chimiques des matériaux utilisés ;
▪ et dans une moindre mesure, du volume de solution déposée sur la tranchée, c'est-à-dire du poids de la colonne de solution au dessus de la tranchée.

En outre, ceci est pondéré par le fait que la solution peut pénétrer dans la première tranchée, le tout étant que la solution n'atteigne pas la couche semi-conductrice pour éviter un court-circuit. Ainsi donc, l'épaisseur de la deuxième couche conductrice peut également intervenir dans le choix des paramètres précédents.

De même, tout ceci est à pondérer par le procédé utilisé pour le dépôt de la solution. Par exemple, avec un dépôt du type jet d'encre, il est possible de déposer des quantités variables de solution, notamment moins de solution sur la première tranchée et plus de solution sur la deuxième tranchée.

Selon un mode de réalisation de l'invention, la formation de la zone de connexion comporte la formation d'une troisième tranchée dans l'empilement, adjacente uniquement à la deuxième tranchée et distincte de celle-ci, depuis la deuxième couche conductrice jusqu'à la première couche conductrice. Cette troisième tranchée permet de séparer et d'isoler les électrodes avant des cellules photovoltaïques.

Selon un autre mode de réalisation de l'invention, la largeur de la deuxième tranchée est choisie de telle sorte que la solution conductrice ne soit pas en contact avec la portion de la deuxième couche semi-conductrice de la deuxième cellule. En d'autres termes la séparation et l'isolation des électrodes avant est réalisée par une largeur suffisante de la deuxième tranchée et par le fait que la solution ne forme pas un pont entre les bords opposés de la deuxième tranchée.

Selon un mode de réalisation de l'invention, les largeurs des première et deuxième tranchées sont sélectionnées en fonction de la viscosité de la solution conductrice. Il est en effet possible d'obtenir le résultat recherché en paramétrant la viscosité de la solution et la largeur des tranchées.

Selon un mode de réalisation de l'invention, le procédé comprend une étape de texturation des parois de la première tranchée par des motifs tridimensionnels. En variante, le procédé comprend une étape de formation de plots sur une surface du substrat libérée par la formation de la première tranchée, la hauteur des plots étant sensiblement égale à celle de la première tranchée. Notamment, la distance latérale minimale sans matière dans la première tranchée est sélectionnée en fonction de la viscosité de la solution conductrice. Plus particulièrement, le procédé comprend la formation d'un motif tridimensionnel périodique comprenant des parties pleines et des parties en creux sur une première paroi de la première tranchée, et la formation du même motif périodique sur une deuxième paroi de la première tranchée, opposée à la première paroi, le motif de la deuxième paroi étant décalé par rapport au motif de la première paroi de manière à mettre face à face les parties pleines du motif de la première paroi avec les parties en creux du motif de la deuxième paroi.

De cette manière, la surface interne de la première tranchée venant au contact de la solution est augmentée, ce qui limite la pénétration de celle-ci. Il peut ainsi être choisi par exemple une solution avec une viscosité moins élevée que la viscosité qui serait nécessaire en l'absence de la texturation et/ou des plots. De même, il est possible de choisir une première tranchée plus large si le procédé et/ou l'application le nécessitent.

Selon un mode de réalisation de l'invention, le dépôt de la solution conductrice est réalisé par sérigraphie, héliographie, flexographie, par jet d'encre ou par pulvérisation.

L'invention a également pour objet un module photovoltaïque tel que défini dans la revendication 12, comprenant au moins deux cellules photovoltaïques comportant chacune une zone semi-conductrice d'absorption de lumière intercalée entre une électrode conductrice arrière et une électrode conductrice avant au moins partiellement transparente à la lumière, les cellules étant connectées électriquement en série au moyen d'une zone de connexion monolithique comportant une tranchée séparant les électrodes arrière.

Plus particulièrement, l'invention a également pour objet un module photovoltaïque tel que défini dans la revendication 12, comprenant au moins deux cellules photovoltaïques adjacentes connectées électriquement en série, comprenant :
▪ un substrat isolant;
▪ un empilement comprenant :
   ∘ une première couche conductrice de l'électricité formée sur le substrat isolant;
   ∘ une couche semi-conductrice comportant une première couche semi-conductrice d'absorption d'un rayonnement électromagnétique prédéterminé, formée sur la première couche conductrice, et une seconde couche semi-conductrice formant une jonction avec la première couche semi-conductrice d'absorption et formée sur celle-ci ; et
   ∘ une deuxième couche conductrice de l'électricité et au moins partiellement transparente audit rayonnement, formée sur la couche semi-conductrice ; et
▪ au moins une zone de connexion divisant l'empilement en une première et une deuxième cellules photovoltaïques adjacentes électriquement connectées uniquement par un chemin électrique entre une portion de la première couche conductrice de la première cellule et une portion de la deuxième couche conductrice de la deuxième cellule.

Selon l'invention, ledit chemin électrique comporte :
▪ une première tranchée réalisée dans l'empilement depuis la deuxième couche conductrice jusqu'au substrat et remplie de gaz ;
▪ une couche de dépôt conducteur d'électricité réalisée sur une zone de la deuxième couche semi-conductrice comprenant la première tranchée et au moins une portion de la deuxième tranchée située du côté de la première tranchée, ledit dépôt ne pénétrant pas dans la première tranchée jusqu'à la première couche conductrice; et
▪ une deuxième tranchée, distincte de la première tranchée, réalisée depuis la deuxième couche conductrice jusqu'à la première couche conductrice, la deuxième tranchée étant remplie de matériau conducteur d'électricité jusqu'à la deuxième couche conductrice, la couche de dépôt conducteur n'étant pas en contact avec la portion de la deuxième couche semi-conductrice de la deuxième cellule.

Ce module est préférentiellement fabriqué selon le procédé précité.

### BREVE DESCRIPTION DES FIGURES

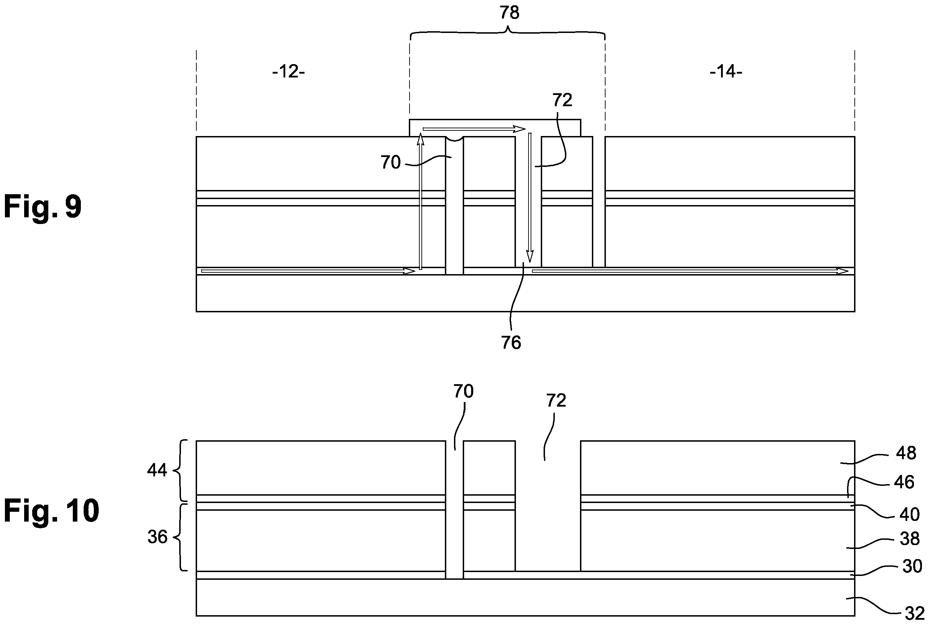

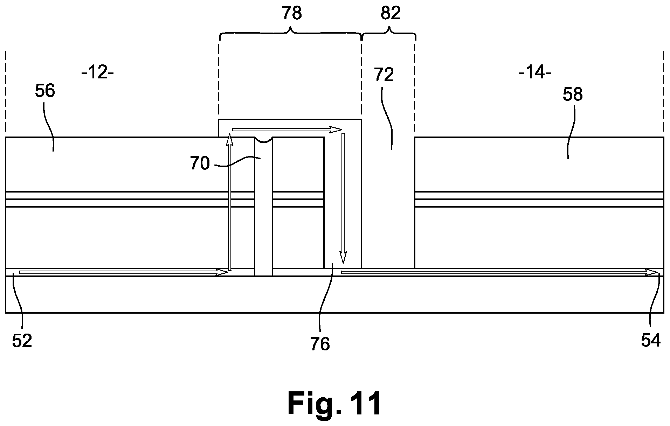

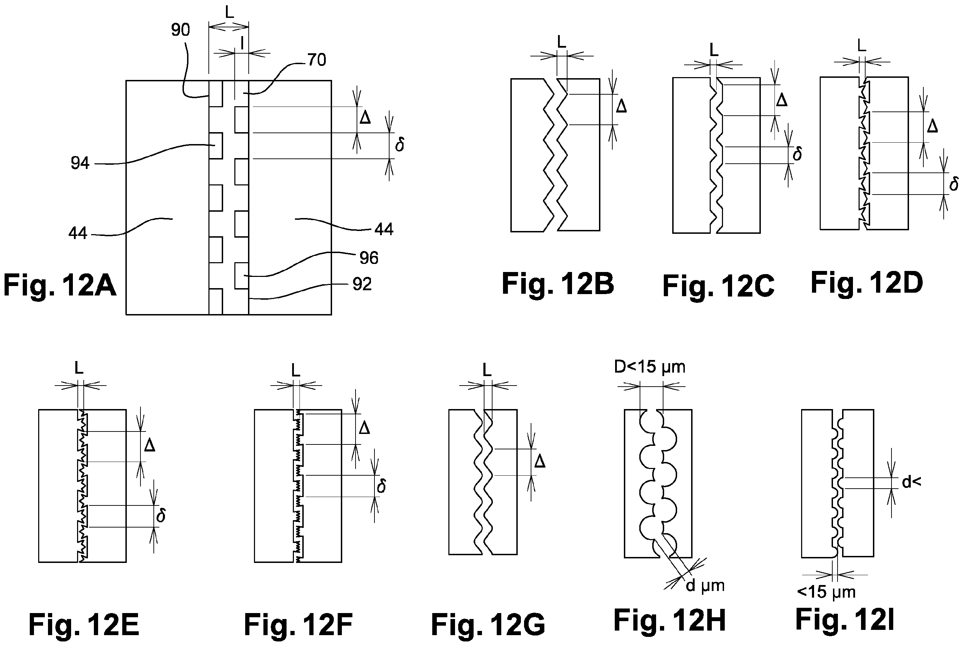

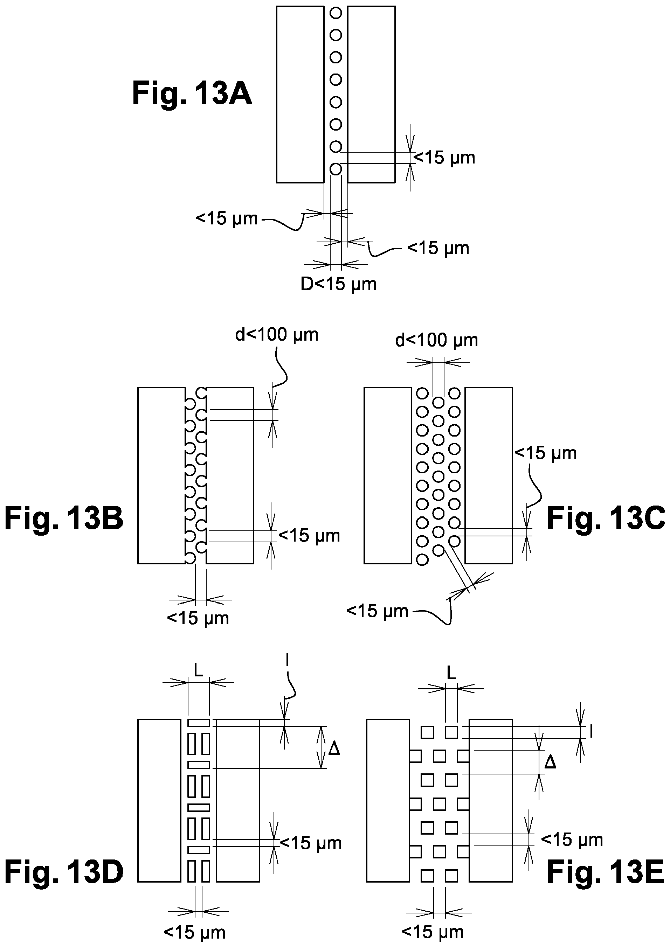

La présente invention sera mieux comprise à la lecture de la description qui va suivre, donnée uniquement à titre d'exemple, et réalisée en relation avec les dessins annexés, dans lesquelles des références identiques désignent des éléments identiques ou analogues, et dans lesquels :
▪ la figure 1 est une vue schématique de la face avant d'un module solaire selon l'état de la technique, tel que décrit dans le préambule ;
▪ les figures 2 à 5 sont des vues en coupe selon le plan A-A de la figure 1 illustrant un procédé de fabrication du module de la figure 1, tel que décrit dans le préambule ;
▪ les figures 6 à 8 sont des vues schématiques en coupe illustrant un procédé de fabrication d'un module photovoltaïque selon un premier mode de réalisation du procédé de l'invention;
▪la figure 9 est une vue schématique en coupe d'un module photovoltaïque que l'on peut obtenir par la procédé de l'invention;
▪ les figures 10 et 11 sont des vues schématiques en coupe illustrant un procédé de fabrication d'un module photovoltaïque selon un deuxième mode de réalisation de l'invention ;
▪ les figures 12A à 12B sont des vues schématiques de dessus d'une tranchée d'isolation électrique entre deux électrodes arrière de cellules photovoltaïques, dont les bords sont pourvus de motifs tridimensionnels selon plusieurs variantes ; et
▪ les figures 13A à 13B sont des vues schématiques de dessus d'une tranchée d'isolation électrique entre deux électrodes arrière de cellules photovoltaïques dans laquelle sont formées des plots selon plusieurs variantes.

### DESCRIPTION DETAILLEE DE L'INVENTION

Il va à présent être décrit en relation avec les figures 6 à 8 un procédé de fabrication d'un module photovoltaïque selon un premier mode de réalisation de l'invention.

Le procédé débute (figure 6) par la formation d'un substrat isolant **32** et la formation d'un empilement comprenant :
▪ une première couche conductrice de l'électricité **30,** formée sur le substrat isolant **32** ;
▪ une couche semi-conductrice **36,** formée sur la couche conductrice **30** ; et
▪ une deuxième couche conductrice de l'électricité **44** et au moins partiellement transparente audit rayonnement, formée sur la couche semi-conductrice d'absorption **36.**

Les couches constitutives de cet empilement sont par exemple de dimensions identiques et réalisées dans les mêmes matériaux que les couches du module photovoltaïque de l'état de la technique décrit en relation avec les figures 1 à 5. Notamment, la couche semi-conductrice **36** est un bicouche comprenant une couche inférieure d'absorption **38** d'un rayonnement électromagnétique prédéterminé et d'une couche supérieure de jonction **40.** La deuxième couche conductrice **44** peut être un bicouche constitué d'une couche inférieure optionnelle **46** et d'une couche supérieure **48,** comme dans l'état de la technique précédemment décrit.

Une fois l'empilement réalisé, le procédé se poursuit par la réalisation de zones de connexion monolithique individualisant les cellules photovoltaïques tout en les connectant électriquement en série.

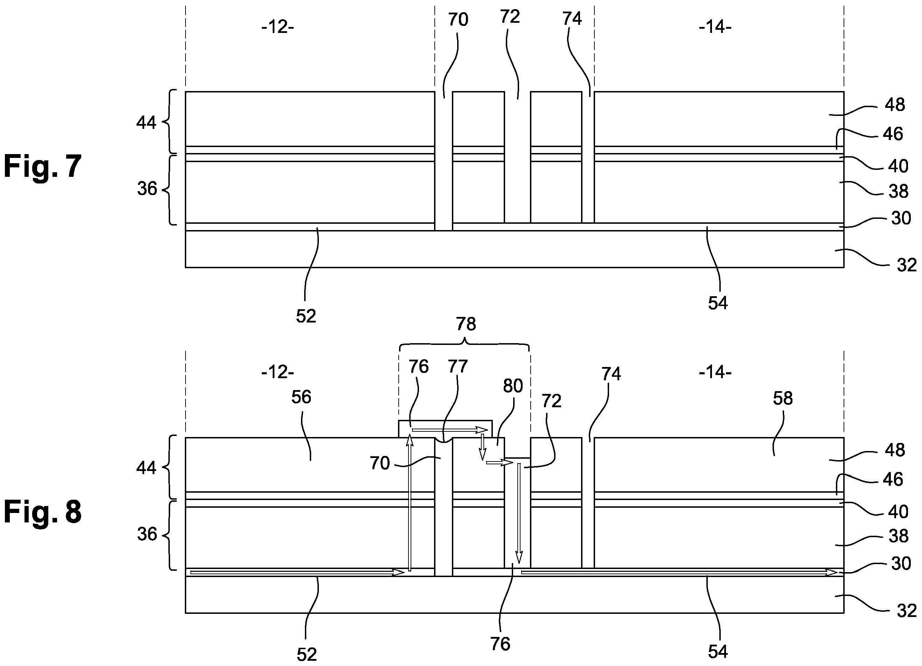

Plus particulièrement, pour chaque zone de connexion monolithique, il est formé trois tranchées parallèles **70, 72, 74** de largeur différente sur la longueur *L* de l'empilement (figure 7).

La première tranchée **70** est réalisée par exemple au moyen d'une gravure par laser dans l'épaisseur de l'empilement jusqu'au substrat **32.** Les deuxième et troisième tranchées **72, 74** sont quant à elles réalisées dans l'épaisseur de l'empilement jusqu'à la couche conductrice **30,** par exemple au moyen d'une rayure par un stylet ou par laser ou par gravure chimique.

La première tranchée **70** sépare donc la couche **30** en deux parties, formant respectivement les électrodes arrière **52, 54** d'une première et d'une seconde cellules photovoltaïques adjacentes **12, 14,** les électrodes arrière **52, 54** étant isolées l'une de l'autre par la tranchée **70,** qui forme une cavité remplie d'air. La troisième tranchée **74,** non adjacente à la première tranchée **70,** sépare quant à elle les électrodes avant **56, 58** des cellules **12, 14,** l'isolation électrique entre les deux électrodes arrière **52, 54** étant réalisée par l'air remplissant la troisième tranchée **74.**

Une solution conductrice **76** est ensuite déposée sur une zone **78** de la seconde couche conductrice **44,** cette zone **78** comprenant la première et la deuxième tranchées **70, 72,** ce dépôt étant réalisé par exemple par sérigraphie ou par pulvérisation. La solution **76** est transparente ou semi-transparente et est par exemple une solution d'oxyde d'indium dopée à l'étain (ou « ITO »), une solution de ZnOAl, une solution d'oxyde d'indium dopée au zinc (ou « IZO »), une solution de polymère avec des nanotubes de carbone, ou une solution de polyme PEDOT (polyéthylènedioxythiophène). En variante, la solution peut être opaque, par exemple être une encore de carbone platine (CPt) ou une encre argent.

La solution **76** a pour fonction de connecter électriquement l'électrode avant **56** de la cellule **12** avec l'électrode arrière **54** de la cellule **14.** A cet effet, la solution **76** recouvre donc la première tranchée **70** et pénètre dans la deuxième tranchée **72** en remplissant celle-ci jusqu'à un niveau suffisamment haut pour être en contact avec la deuxième couche conductrice **44.**

Toutefois, afin d'éviter un court-circuit entre l'électrode avant **54** et la couche semi-conductrice d'absorption **38** de la cellule **74,** ou de manière encore plus préjudiciable avec l'électrode arrière **52,** la solution **76** ne pénètre pas dans la première tranchée **70** et forme éventuellement uniquement une goutte **77** à l'intérieur de la tranchée **70,** ou bien la solution **76** pénètre dans la première tranchée **70** mais à une profondeur telle qu'elle n'atteint pas la couche semi-conductrice d'absorption **38.**

La solution conductrice **76** est alors solidifiée, par exemple par évaporation d'un solvant s'il s'agit d'une solution à base de solvant ou par thermodurcissage s'il s'agit d'un matériau thermodurcissant.

Les cellules photovoltaïques **12** et **14** sont ainsi connectées électriquement en série par le chemin électrique illustré par les flèches de la figure 8, qui relie l'électrode arrière **52** de la cellule **12** avec l'électrode avant de la cellule **14.**

La figure 8 illustre une variante dans laquelle le dépôt de la solution **76** a donné lieu à une rupture **80** entre d'une part la solution solidifiée déposée sur la tranchée **70** et d'autre part la solution solidifiée déposée dans la deuxième tranchée **72.** La zone de rupture **80,** dont les dimensions sont ici exagérées, peut par exemple survenir en raison d'une quantité limitée de solution déposée aux abords de la seconde tranchée **72** et/ou du processus de solidification.

La figure 9 illustre une variante dans laquelle une telle rupture est absente. Par exemple, le volume de solution déposé dans la deuxième tranchée **72** est plus important que précédemment, de sorte que la solution remplit totalement la deuxième tranchée et forme, une fois figée, une zone continue. Dans cette variante, le chemin électrique diffère de celui de la figure 8 et comporte uniquement des matériaux conducteurs.

Dans les modes de réalisation venant d'être décrits, la séparation des électrodes avant de deux cellules adjacentes **12, 14** est mise en oeuvre au moyen de la troisième tranchée **74.**

Un procédé de fabrication d'un module photovoltaïque selon un second mode de réalisation de l'invention est décrit en relation avec les figures 10 et 11. Selon ce second mode de réalisation, l'individualisation et la connexion de deux cellules adjacentes sont réalisés au moyen uniquement de deux tranchées. Plus particulièrement, le procédé débute par la formation de l'empilement des couches **30, 32, 36, 44** comme décrit en relation avec la figure 6, et se poursuit par la formation des première et deuxième tranchées **70** et **72** comme décrit en relation avec la figure 7 (figure 10).

Une solution conductrice **76** est ensuite déposée sur une zone **78** de la seconde couche conductrice **44** comprenant la première et la deuxième tranchées **70, 72,** ce dépôt étant réalisé par exemple par jet d'encre, par pulvérisation ou par sérigraphie.

A la différence des modes de réalisation précédents, la solution conductrice **76** et/ou la largeur de la deuxième tranchée **72** sont choisies de telle sorte que la solution **76** n'atteint pas le bord de la deuxième tranchée **72** correspondant à la deuxième cellule **14** (figure 11). Il existe ainsi, dans la deuxième tranchée **72,** un espace **82** rempli d'air, qui isole les électrodes avant **56, 58** des cellules adjacentes **12, 14.** Le chemin électrique connectant l'électrode arrière **52** de la cellule **12** avec l'électrode avant **58** de la deuxième cellule est illustré par les flèches. Dans l'exemple illustré aux figures 10 et 11, la solution **76** forme une zone continue mais peut, en variante, comporter une rupture analogue à celle de la figure 8.

La non-pénétration ou la pénétration limitée de la solution **76** dans la première tranchée **70** est obtenue en paramétrant la largeur de la première tranchée, la viscosité de la solution déposée, l'épaisseur de la deuxième couche conductrice **44,** la précision du procédé de dépôt, et le volume déposé sur la première tranchée **70.**

Usuellement, la couche semi-conductrice d'absorption **38** représente entre un quart et un tiers de la hauteur totale de la première tranchée **70.** En s'assurant que la solution **76** ne pénètre pas plus que le quart de la tranchée **70,** on évite donc tout risque de court-circuit car il n'y aura pas de contact entre la solution **76** et la couche semi-conductrice d'absorption **38,** et donc a fortiori avec la couche conductrice **30.**

Notamment, il a été observé que pour une tranchée **70** de largeur supérieure à 15 micromètres, une viscosité de la solution **76** supérieure à 3,2 cPoises (mPa.s) permet d'obtenir la non-pénétration, ou la pénétration limitée, recherchée. En revanche pour une largeur inférieure de la tranchée **70,** par exemple dans un but de miniaturisation, une solution **76** avec une viscosité plus faible peut être utilisée.

Par exemple, une encre CPt d'une viscosité de 3,2 cPoises, et donc inférieure à la limite de 50 cPoises maximum usuellement requise pour une pulvérisation, déposée par pulvérisation sur une épaisseur de 10 micromètres avec une fréquence d'ultrason de 48 kHz, et une largeur de la première tranchée inférieure à 15 micromètres permettent de conserver l'encre CPt en surface avec une pénétration faible dans la tranchée **70.**

D'une manière générale, il est possible de choisir la largeur de la tranchée une fois les autres paramètres du dépôt (viscosité de la solution, volume de solution déposé, épaisseur de la deuxième couche conductrice, type de procédé de dépôt utilisé) déterminés.

Par ailleurs, il est possible d'utiliser des procédés de dépôt qui permettent de déposer des volumes différents de solution sur les première et deuxième tranchées, ce qui permet une plus grande liberté de choix pour la solution, notamment sa viscosité.

Par ailleurs, il est également possible de régler la pénétration de la solution dans la première tranchée en choisissant le type de solidification de la solution. Par exemple, en choisissant une solution thermodurcissable, il est possible de stopper la progression de cette solution dans la première tranchée en la chauffant. De même, en choisissant une solution de polymère réticulable, il est possible de stopper sa progression en la soumettant à un rayonnement approprié.

Il a été décrit une première tranchée **70** dont les bords sont plans. De manière à limiter la pénétration d'une solution dans la première tranchée **70,** les parois transversales de celle-ci comprennent, au moins dans la partie supérieure de la tranchée **70,** une texturation de surface de manière à former des motifs tridimensionnels, comme par exemple illustré sur la vue de dessus de la figure 12A.

Sur cette figure, chacune des parois **90, 92** de la première tranchée **70** comporte un réseau périodique de motifs **94, 96** à section rectangulaire, le réseau **94** d'une paroi **90** étant décalé par rapport au réseau **96** de l'autre paroi **92** pour qu'un motif d'une paroi soit agencé en face d'une partie en creux de l'autre paroi. La géométrie des motifs, définie par les paramètres L, 1, Δ, δ illustrés à la figure 12A, est par ailleurs choisie de manière à ce que la distance latérale minimale entre un point quelconque de la première paroi et un point quelconque de la seconde paroi soit inférieure à la distance nécessaire pour éviter la pénétration de la solution dans la tranchée **70,** par exemple inférieure à 15 micromètres dans l'exemple précédent du dépôt d'une encre CPt telle que précédemment décrite. Les motifs permettent ainsi, à largeur de tranchée égale, d'augmenter la surface au contact avec la solution, et donc de pouvoir choisir une solution moins visqueuse si l'application le nécessite, par exemple en raison de contraintes sur le procédé de dépôt ou sur la fabrication de la solution.

Il a été décrit des motifs à section rectangulaire. Cependant, comme illustré aux figures 12B à 12I, d'autres motifs sont possibles sur les parois de la première tranchée, la géométrie des motifs étant choisie de manière à obtenir la distance latérale minimale qui évite ou limite la pénétration de la solution, entre un point quelconque de la première paroi et un point quelconque de la seconde paroi.

De même, comme illustré aux figures 13A à 13E, il est également possible de prévoir, en complément des motifs des parois, ou à la place de ceux-ci, des plots ménagés dans le fond de la première tranchée jusqu'au bord supérieur de celle-ci. La géométrie de tels plots est également choisie de manière à obtenir la distance latérale minimale sans matière souhaitée dans la première tranchée.

Selon l'invention, il est ainsi obtenu :
▪ une isolation électrique accrue entre les électrodes arrière de cellules photovoltaïques adjacentes, d'où un gain des performances du module ;
▪ une fabrication simple de mise en oeuvre d'où un coût plus faible.

## Revendications

1. Procédé de fabrication d'un module photovoltaïque comprenant au moins deux cellules photovoltaïques adjacentes (12, 14) connectées électriquement en série, comprenant :
▪ la formation d'un substrat isolant (32) ;
▪ la formation d'un empilement comprenant :
∘ une première couche conductrice de l'électricité (30) formée sur le substrat isolant (30);
∘ une couche semi-conductrice (36) comportant une première couche semi-conductrice d'absorption (38) d'un rayonnement électromagnétique prédéterminé, formée sur la première couche conductrice (30), et une seconde couche semi-conductrice (40) formant une jonction avec la première couche semi-conductrice d'absorption (38) et formée sur celle-ci ; et
∘ une deuxième couche conductrice de l'électricité (44) et au moins partiellement transparente audit rayonnement, formée sur la couche semi-conductrice (36) ;
▪ la formation d'au moins une zone de connexion (78) divisant l'empilement en une première et une deuxième cellules photovoltaïques adjacentes (12, 14) électriquement connectées uniquement par un chemin électrique entre une portion (52) de la première couche conductrice (30) de la première cellule (12) et une portion (54) de la deuxième couche conductrice (44) de la deuxième cellule (14),
***caractérisé* en ce que** la formation dudit chemin électrique comporte :
▪ la formation d'une première tranchée (70) dans l'empilement depuis la deuxième couche conductrice (44) jusqu'au substrat (32) ;
▪ la formation d'une deuxième tranchée (72), distincte de la première tranchée (70), depuis la deuxième couche conductrice (44) jusqu'à la première couche conductrice (30); et
▪ le dépôt d'une solution conductrice (76) sur une zone (78) de la deuxième couche semi-conductrice (44) comprenant la première tranchée (70) et au moins une portion de la deuxième tranchée (72) située du côté de la première tranchée (70), la géométrie des tranchées (70, 72), l'épaisseur de la deuxième couche conductrice (44), et la quantité et les propriétés de la solution conductrice (76) lors de son dépôt étant choisies de manière à ce que la solution conductrice (76) ne pénètre pas dans la première tranchée (70) jusqu'à la première couche conductrice (30) et pénètre dans la deuxième tranchée (72) jusqu'à la première couche conductrice (30).

2. Procédé de fabrication d'un module photovoltaïque selon la revendication 1, ***caractérisé* en ce que** la solution ne pénètre pas dans la première tranchée (70) jusqu'à la couche d'absorption (38).

3. Procédé de fabrication d'un module photovoltaïque selon la revendication 1 ou 2, ***caractérisé* en ce que** la formation de la zone de connexion (78) comporte la formation d'une troisième tranchée (74) dans l'empilement, adjacente uniquement à la deuxième tranchée (72) et distincte de celle-ci, depuis la deuxième couche conductrice (38) jusqu'à la première couche conductrice (30).

4. Procédé de fabrication d'un module photovoltaïque selon la revendication 1 ou 2, ***caractérisé* en ce que** la largeur de la deuxième tranchée (72) est choisie de telle sorte que la solution conductrice (76) ne soit pas en contact avec la portion de la deuxième couche semi-conductrice (36) de la deuxième cellule (14).

5. Procédé de fabrication d'un module photovoltaïque selon l'une quelconque des revendications précédentes, ***caractérisé* en ce que** les largeurs des première et deuxième tranchées (70, 72) sont sélectionnées en fonction de la viscosité de la solution conductrice (76).

6. Procédé de fabrication d'un module photovoltaïque selon l'une quelconque des revendications précédentes, ***caractérisé* en ce qu'**il comprend une étape de texturation des parois (90, 92) de la première tranchée (70) par des motifs tridimensionnels (94, 96).

7. Procédé de fabrication d'un module photovoltaïque selon l'une quelconque des revendications, ***caractérisé* en ce qu'**il comprend une étape de formation de plots sur une surface du substrat (32) libérée par la formation de la première tranchée (70), la hauteur des plots étant sensiblement égale à celle de la première tranchée (70).

8. Procédé de fabrication d'un module photovoltaïque selon la revendication 5 ou 6, ***caractérisé* en ce que** la distance latérale minimale sans matière dans la première tranchée (70) est sélectionnée en fonction de la viscosité de la solution conductrice (76).

9. Procédé de fabrication d'un module photovoltaïque selon la revendication 6, ***caractérisé* en ce qu'**il comprend la formation d'un motif tridimensionnel (94) périodique comprenant des parties pleines et des parties en creux sur une première paroi (90) de la première tranchée (70), et la formation du même motif périodique (96) sur une deuxième paroi (92) de la première tranchée (70), opposée à la première paroi (90), le motif (94) de la deuxième paroi (92) étant décalé par rapport au motif (94) de la première paroi (90) de manière à mettre face à face les parties pleines du motif (94) de la première paroi (90) avec les parties en creux du motif (96) de la deuxième paroi (92).

10. Procédé de fabrication d'un module photovoltaïque selon l'une quelconque des revendications précédentes, ***caractérisé* en ce que** le volume de solution conductrice (76) dans la première tranchée (70) est inférieur au volume de solution conductrice (76) dans la deuxième tranchée (72).

11. Procédé de fabrication d'un module photovoltaïque selon l'une quelconque des revendications précédentes, ***caractérisé* en ce que** le dépôt de la solution conductrice est réalisé par sérigraphie ou héliographie.

12. Module photovoltaïque comprenant au moins deux cellules photovoltaïques adjacentes (12, 14) connectées électriquement en série, comprenant :
▪ un substrat isolant (32) ;
▪ un empilement comprenant :
∘ une première couche conductrice de l'électricité (30) formée sur le substrat isolant (30);
∘ une couche semi-conductrice (36) comportant une première couche semi-conductrice d'absorption (38) d'un rayonnement électromagnétique prédéterminé, formée sur la première couche conductrice (30), et une seconde couche semi-conductrice (40) formant une jonction avec la première couche semi-conductrice d'absorption (38) et formée sur celle-ci ; et
∘ une deuxième couche conductrice de l'électricité (44) et au moins partiellement transparente audit rayonnement, formée sur la couche semi-conductrice (36) ; et
▪ au moins une zone de connexion (78) divisant l'empilement en une première et une deuxième cellules photovoltaïques adjacentes (12, 14) électriquement connectées uniquement par un chemin électrique entre une portion (52) de la première couche conductrice (30) de la première cellule (12) et une portion (54) de la deuxième couche conductrice (44) de la deuxième cellule (14),
***caractérisé* en ce que** :
▪ la première et la deuxième cellule photovoltaïque (12, 14) sont individualisées par uniquement une première et une deuxième tranchées distinctes (70, 72); et
▪ **en ce que** ledit chemin électrique comporte :
∘ la première tranchée (70), réalisée dans l'empilement depuis la deuxième couche conductrice (44) jusqu'au substrat (32) et remplie de gaz ;
∘ une couche de dépôt conducteur d'électricité (76) réalisée sur une zone (78) de la deuxième couche semi-conductrice (44) comprenant la première tranchée (70) et au moins une portion de la deuxième tranchée (72) située du côté de la première tranchée (70), ledit dépôt (76) ne pénétrant pas dans la première tranchée (70) jusqu'à la première couche conductrice (30) ; et
∘ la deuxième tranchée (72), réalisée depuis la deuxième couche conductrice (44) jusqu'à la première couche conductrice (30), la deuxième tranchée étant remplie de matériau conducteur d'électricité jusqu'à la deuxième couche conductrice (44), la couche de dépôt (76) n'étant pas en contact avec la portion de la deuxième couche semi-conductrice (36) de la deuxième cellule (14).

13. Module photovoltaïque selon la revendication 12, ***caractérisé* en ce que** la couche de dépôt (76) ne pénètre pas dans la première tranchée (70) jusqu'à la couche d'absorption (38).

14. Module photovoltaïque selon la revendication 12 ou 13, ***caractérisé* en ce qu'**il comprend une texturation des parois (90, 92) de la première tranchée (70) par des motifs tridimensionnels (94, 96).

15. Module photovoltaïque selon l'une quelconque des revendications 12 à 14, ***caractérisé* en ce qu'**il comprend des plots formés sur une surface du substrat (32) libérée par la formation de la première tranchée (70), la hauteur des plots étant sensiblement égale à celle de la première tranchée (70).

16. Module photovoltaïque selon l'une quelconque des revendications 12 à 15, ***caractérisé* en ce qu'**il comprend un motif tridimensionnel (94) périodique comprenant des parties pleines et des parties en creux sur une première paroi (90) de la première tranchée (70), et un motif périodique (96), identique au motif (94) de la première paroi (90), sur une deuxième paroi (92) de la première tranchée (70), opposée à la première paroi (90), le motif (94) de la deuxième paroi (92) étant décalé par rapport au motif (94) de la première paroi (90) de manière à mettre face à face les parties pleines du motif (94) de la première paroi (90) avec les parties en creux du motif (96) de la deuxième paroi (92).

## Patentansprüche

1. Ein Verfahren zur Herstellung eines Photovoltaikmoduls, bestehend aus mindestens zwei nebeneinanderliegenden, in Reihe geschalteten photovoltaischen Zellen (12, 14) umfassend:
▪ die Bildung eines isolierenden Substrats (32);
▪ die Bildung eines Stapels, umfassend:
∘ eine erste elektrisch leitfähige Schicht (30), die auf dem isolierenden Substrat (30) gebildet ist,
∘ eine Halbleiterschicht (36) mit einer ersten Halbleiterschicht zur Absorption (38) einer festgelegten elektromagnetischen Strahlung, die auf der ersten leitfähigen Schicht (30) gebildet ist, und mit einer zweiten Halbleiterschicht (40), die einen Übergangs zur ersten Absorptionshalbleiterschicht (38) bildet und auf dieser gebildet ist; und
∘ eine zweite leitfähige Schicht (44), zumindest teilweise transparent, gegenüber dieser Strahlung, die auf der Absorptionsschicht (36) gebildet ist;
▪ die Bildung mindestens einer Verbindungszone (78), die den Stapel in eine erste und eine zweite nebeneinanderliegende, photovoltaische Zellen (12, 14) unterteilt, die nur durch einen elektrischen Pfad zwischen einem Teilstück (52) der ersten leitfähigen Schicht (30) der ersten Zelle (12) und einem zweiten Teilstück (54) der zweiten leitfähigen Schicht (44) der zweiten Zelle (14) verbunden sind;
***dadurch gekennzeichnet, dass*** die Bildung dieses elektrischen Pfades folgendes umfasst:
▪ die Bildung eines ersten Grabens (70) im Stapel von der zweiten leitfähigen Schicht (44) aus bis zum (32) Substrat;
▪ Bildung eines zweiten Grabens (72), die vom ersten Graben (70) getrennt ist, von der zweiten leitfähigen Schicht (44) aus bis zur ersten leitfähigen Schicht (30); und
▪ Ablagern einer leitfähigen Lösung (76) auf einer Zone (78) der zweiten leitfähigen Schicht (44), die den ersten Graben (70) und zumindest ein Teilstück des zweiten Grabens (72) umfasst, der sich auf der Seite des ersten Grabens (70) befindet, wobei die Geometrie der Gräben (70, 72), die Dicke der zweiten leitfähigen Schicht (44) und die Menge sowie die Eigenschaften der leitfähigen Lösung (76) bei ihrem Ablagern so gewählt werden, dass die leitfähige Lösung (76) nicht in den ersten Graben (70) bis zur ersten leitfähigen Schicht (30) eindringt und in den zweiten Graben (72) bis zur ersten leitfähigen Schicht (30) eindringt.

2. Verfahren zur Herstellung eines Photovoltaikmoduls gemäß Anspruch 1, ***dadurch gekennzeichnet, dass*** die Lösung nicht in den ersten Graben (70) bis zur Absorptionsschicht (38) eindringt.

3. Verfahren zur Herstellung eines Photovoltaikmoduls gemäß Anspruch 1 oder 2, ***dadurch gekennzeichnet, dass*** die Bildung der Verbindungszone (78) die Bildung eines dritten Grabens (74) im Stapel umfasst, der nur neben dem zweiten Graben (72) liegt und von diesem von der zweiten leitfähigen Schicht (38) aus bis zur ersten leitfähigen Schicht (30) getrennt ist.

4. Verfahren zur Herstellung eines Photovoltaikmoduls gemäß Anspruch 1 oder 2, ***dadurch gekennzeichnet, dass*** die Breite des zweiten Grabens (72) so gewählt wird, dass die leitfähige Lösung (76) keinen Kontakt mit dem Teilstück der zweiten Halbleiterschicht (36) der zweiten Zelle (14) hat.

5. Verfahren zur Herstellung eines Photovoltaikmoduls gemäß einem der vorangehenden Ansprüche, ***dadurch gekennzeichnet, dass*** die Breite des ersten und zweiten Grabens (70, 72) entsprechend der Viskosität der leitfähigen Lösung (76) gewählt wird.

6. Verfahren zur Herstellung eines Photovoltaikmoduls gemäß einem der vorangehenden Ansprüche, ***dadurch gekennzeichnet, dass*** es einen Schritt zur Texturierung der Wände (90, 92) des ersten Grabens (70) durch dreidimensionale Motive (94, 96) umfasst.

7. Verfahren zur Herstellung eines Photovoltaikmoduls gemäß einem der vorangehenden Ansprüche, ***dadurch gekennzeichnet, dass*** es einen Schritt der Bildung von Plots auf einer Substratoberfläche (32) umfasst, die durch die Bildung des ersten Grabens (70) freigelegt wird, wobei die Höhe der Plots deutlich gleich der des ersten Grabens (70) ist.

8. Verfahren zur Herstellung eines Photovoltaikmoduls gemäß Anspruch 5 oder 6 ***dadurch gekennzeichnet, dass*** der seitliche Mindestabstand ohne Material des ersten Grabens (70) entsprechend der Viskosität der leitfähigen Lösung (76) gewählt wird.

9. Verfahren zur Herstellung eines Photovoltaikmoduls gemäß Anspruch 6 ***dadurch gekennzeichnet, dass*** es die Bildung eines regelmäßig wiederholten dreidimensionalen Motivs (94), das volle Teile und hohle Teile auf einer ersten Wand (90) des ersten Grabens (70) enthält, sowie die Bildung desselben, regelmäßig wiederholten Motivs (96) auf einer zweiten Wand (92) des ersten Grabens (70) gegenüber der ersten Wand (90) umfasst, wobei das Motiv (94) der zweiten Wand (92) bezogen auf das Motiv (94) der ersten Wand (90) versetzt ist, so dass die vollen Teile des Motivs (94) der ersten Wand (90) gegenüber den hohlen Teilen des Motivs (96) der zweiten Wand (92) liegen.

10. Verfahren zur Herstellung eines Photovoltaikmoduls gemäß einem der vorangehenden Ansprüche, **dadurch gekennzeichnet, dass** die Menge der leitfähigen Lösung (76) im ersten Graben (70) geringer ist, als die Menge der leitfähigen Lösung (76) im zweiten Graben (72).

11. Verfahren zur Herstellung eines Photovoltaikmoduls gemäß einem der vorangehenden Ansprüche, **dadurch gekennzeichnet, dass** die Ablagerung der leitfähigen Lösung durch Siebdruck oder Heliographie ausgeführt wird.

12. Photovoltaikmodul, bestehend aus mindestens zwei nebeneinanderliegenden, in Reihe geschalteten photovoltaischen Zellen (12, 14) umfassend:
▪ ein isolierendes Substrat (32);
▪ einen Stapel, bestehend aus:
∘ einer ersten elektrisch leitfähigen Schicht (30), die auf dem isolierenden Substrat (30) gebildet ist;
∘ einer Halbleiterschicht (36) mit einer ersten Halbleiterschicht zur Absorption (38) einer festgelegten elektromagnetischen Strahlung, die auf der ersten leitfähigen Schicht (30) gebildet ist, und mit einer zweiten Halbleiterschicht (40), die einen Übergangs zur ersten Absorptionshalbleiterschicht (38) bildet und auf dieser gebildet ist; und
∘ einer zweiten leitfähigen Schicht (44), zumindest teilweise transparent, gegenüber dieser Strahlung, die auf der Absorptionsschicht (36) gebildet ist; und
▪ mindestens eine Verbindungszone (78), die den Stapel in eine erste und eine zweite nebeneinanderliegende photovoltaische Zellen (12, 14) unterteilt, die elektrisch nur durch einen elektrischen Pfad zwischen einem Teilstück (52) der ersten leitfähigen Schicht (30) der ersten Zelle (12) und ein zweites Teilstück (54) der zweiten leitfähigen Schicht (44) der zweiten Zelle (14) verbunden sind;
***dadurch gekennzeichnet, dass*:**
▪ die erste und die zweite photovoltaische Zelle (12, 14) voneinander nur durch einen ersten und einen zweiten Graben (70, 72) abgetrennt sind, die voneinander getrennt sind; und
▪ dass dieser elektrische Pfad umfasst:
∘ den ersten Graben (70), der im Stapel von der zweiten leitfähigen Schicht (44) aus bis zum Substrat (32) ausgeführt wird und mit Gas gefüllt ist;
∘ eine elektrisch leitfähige Ablagerung (76), die in einer Zone (78) der zweiten Halbleiterschicht (44) ausgeführt ist, die den ersten Graben (70) und zumindest ein Teilstück des zweiten Grabens (72), der sich auf der Seite des ersten Grabens (70) befindet, umfasst, wobei diese Ablagerung (76) nicht in den ersten Graben (70) bis zur ersten leitfähigen Schicht (30) eindringt; und
∘ den zweiten Graben (72), der von der zweiten leitfähigen Schicht (44) aus bis zur ersten leitfähigen Schicht (30) ausgeführt ist, wobei der zweite Graben mit einem elektrisch leitfähigen Material gefüllt ist bis zur zweiten leitfähigen Schicht (44), die Ablagerung (76) keinen Kontakt mit dem Teilstück der zweiten Halbleiterschicht (36) der zweiten Zelle (14) hat.

13. Photovoltaikmodul gemäß Anspruch 12, ***dadurch gekennzeichnet, dass*** die Ablagerungsschicht (76) nicht in den ersten Graben (70) bis zur Absorptionsschicht (38) eindringt.

14. Photovoltaikmodul gemäß Anspruch 12 oder 13, ***dadurch gekennzeichnet, dass*** es eine Texturierung der Wände (90, 92) des ersten Grabens (70) durch dreidimensionale Motive (94, 96) umfasst.

15. Photovoltaikmodul gemäß Anspruch 12 bis 14, ***dadurch gekennzeichnet, dass*** es Plots, die auf einer Substratoberfläche (32) gebildet sind, umfasst, die durch die Bildung des ersten Grabens (70) freigelegt wird, wobei die Höhe der Plots deutlich gleich der des ersten Grabens (70) ist.

16. Photovoltaikmodul gemäß einem der Ansprüche 12 bis 15 ***dadurch gekennzeichnet, dass*** es ein regelmäßig wiederholtes dreidimensionales Motiv (94), das volle Teile und hohle Teile auf einer ersten Wand (90) des ersten Grabens (70) enthält, sowie ein regelmäßig wiederholtes Motiv (96) umfasst, das dem Motiv (94) der ersten Wand (90) auf einer zweiten Wand (92) des ersten Grabens (70) gegenüber der ersten Wand (90) gleich ist, wobei das Motiv (94) der zweiten Wand (92) bezogen auf das Motiv (94) der ersten Wand (90) versetzt ist, so dass die vollen Teile des Motivs (94) der ersten Wand (90) gegenüber den holen Teilen des Motivs (96) der zweiten Wand (92) liegen.

## Claims

1. A method for manufacturing a photovoltaic module comprising at least two series-connected adjacent photovoltaic cells (12, 14), comprising:
▪ forming an insulating substrate (32);
▪ forming a stack comprising:
∘ a first electrically-conductive layer (30) formed on the insulating substrate (30);
∘ a semiconductor layer (36) comprising a first semiconductor layer (38) for absorbing a predetermined electromagnetic radiation, formed on the first conductive layer (30), and a second semiconductor layer (40) forming a junction with the first semiconductor absorption layer (38) and formed thereon; and
∘ a second electrically-conductive layer (44) at least partly transparent to said radiation, formed on the semiconductor layer (36);
▪ forming at least one connection area (78) dividing the stack into a first and a second electrically-adjacent photovoltaic cells (12, 14) only connected by an electric path between a portion (52) of the first conductive layer (30) of the first cell (12) and a portion (54) of the second conductive layer (44) of the second cell (14),
***characterized in that*** the forming of said electric path comprises:
▪ forming a first trench (70) in the stack from the second conductive layer (44) to the substrate (32);
▪ forming a second trench (72), separate from the first trench (70), from the second conductive layer (44) to the first conductive layer (30); and
▪ depositing a conductive solution (76) on an area (78) of the second semiconductor layer (44) comprising the first trench (70) and at least a portion of the second trench (72) located on the side of the first trench (70), the geometry of the trenches (70, 72), the thickness of the second conductive layer (44), and the quantity and the properties of the conductive solution (76) on deposition thereof being selected so that the conductive solution (76) does not penetrate into the first trench (70) all the way to the first conductive layer (30) and penetrates into the second trench (72) all the way to the first conductive layer (30).

2. The photovoltaic module manufacturing method of claim 1, ***characterized in that*** the solution does not penetrate into the first trench (70) all the way to the absorption layer (38).

3. The photovoltaic module manufacturing method of claim 1 or 2, ***characterized in that*** the forming of the connection area (78) comprises forming a third trench (74) in the stack, only adjacent to the second trench (72) and distinct therefrom, from the second conductive layer (38) to the first conductive layer (30).

4. The photovoltaic module manufacturing method of claim 1 or 2, ***characterized in that*** the width of the second trench (72) is selected so that the conductive solution (76) is not in contact with the portion of the second semiconductor layer (36) of the second cell (14).

5. The photovoltaic module manufacturing method of any of the foregoing claims, ***characterized in that*** the widths of the first and second trenches (70, 72) are selected according to the viscosity of the conductive solution (76).

6. The photovoltaic module manufacturing method of any of the foregoing claims, ***characterized in that*** it comprises a step of texturing the walls (90, 92) of the first trench (70) with three-dimensional patterns (94, 96).

7. The photovoltaic module manufacturing method of any of the foregoing claims, ***characterized in that*** it comprises a step of forming pads on a surface of the substrate (32) exposed by the forming of the first trench (70), the height of the pads being substantially equal to that of the first trench (70).

8. The photovoltaic module manufacturing method of claim 5 or 6, ***characterized in that*** the minimum lateral distance without matter in the first trench (70) is selected according to the viscosity of the conductive solution (76).

9. The photovoltaic module manufacturing method of claim 6, ***characterized in that*** it comprises forming a periodic three-dimensional pattern (94) comprising raised portions and recessed portions on a first wall (90) of the first trench (70), and forming the same periodic pattern (96) on a second wall (92) of the first trench (70), opposite to the first wall (90), the pattern (94) of the second wall (92) being shifted with respect to the pattern (94) of the first wall (90) to have the raised portions of the pattern (94) of the first wall (90) face the hollow portions of the pattern (96) of the second wall (92).

10. The photovoltaic module manufacturing method of any of the foregoing claims, ***characterized in that*** the volume of conductive solution (76) in the first trench (70) is smaller than the volume of conductive solution (76) in the second trench (72).

11. The photovoltaic module manufacturing method of any of the foregoing claims, ***characterized in that*** the deposition of the conductive solution is performed by screen printing or heliography.

12. A photovoltaic module comprising at least two series-connected adjacent photovoltaic cells (12, 14), comprising:
▪ an insulating substrate (32);
▪ a stack comprising:
∘ a first electrically-conductive layer (30) formed on the insulating substrate (30);
∘ a semiconductor layer (36) comprising a first semiconductor layer (38) for absorbing a predetermined electromagnetic radiation, formed on the first conductive layer (30), and a second semiconductor layer (40) forming a junction with the first semiconductor absorption layer (38) and formed thereon; and
∘ a second electrically-conductive layer (44) at least partly transparent to said radiation, formed on the semiconductor layer (36); and
▪ at least one connection area (78) dividing the stack into a first and a second adjacent photovoltaic cells (12, 14) electrically connected by an electric path only between a portion (52) of the first conductive layer (30) of the first cell (12) and a portion (54) of the second conductive layer (44) of the second cell (14),
***characterized :***
▪ in that first and second photovoltaic cells (12, 14) are individualized by only a first and a second separated trenches (70, 72) and
▪ in that said electric path comprises:
∘ the first trench (70) formed in the stack from the second conductive layer (44) to the substrate (32) and filled with gas;
∘ an electrically-conductive deposit layer (76) formed on an area (78) of the second semiconductor layer (44) comprising the first trench (70) and at least a portion of the second trench (72) located on the side of the first trench (70), where said deposit (76) does not penetrate into the first trench (70) all the way to the first conductive layer (30); and
o the second trench (72) formed from the second conductive layer (44) to the first conductive layer (30), the second trench being filled with an electrically-conductive material all the way to the second conductive layer (44), the deposition layer (76) being not in contact with the portion of the second semiconductor layer (36) of the second cell (14).

13. The photovoltaic module of claim 12, ***characterized in that*** the deposit layer (76) does not penetrate into the first trench (70) all the way to the absorption layer (38).

14. The photovoltaic module of any of claims 12 or 13, ***characterized in that*** it comprises a texturing of the walls (90, 92) of the first trench (70) with three-dimensional patterns (94, 96).

15. The photovoltaic module of any of claims 12 to 14, ***characterized in that*** it comprises pads formed on a surface of the substrate (32) exposed by the forming of the first trench (70), the height of the pads being substantially equal to that of the first trench (70).

16. The photovoltaic module of any of claims 12 to 15, ***characterized in that*** it comprises a periodic three-dimensional pattern (94) comprising raised portions and recessed portions on a first wall (90) of the first trench (70), and a periodic pattern (96) identical to the pattern (94) of the first wall (90) on a second wall (92) of the first trench (70), opposite to the first wall (90), the pattern (94) of the second wall (92) being shifted with respect to the pattern (94) of the first wall (90) to have the raised portions of the pattern (94) of the first wall (90) face the hollow portions of the pattern (96) of the second wall (92).
